# EUROPEAN PATENT APPLICATION

(11) **EP 4 328 279 A1**
(43) Date of publication of application: **28.02.2024**
(21) Application number: 22795787.5
(22) Date of filing: 26.04.2022
(51) Int. Cl.: C09J 4/02, C09J 11/06, C08F 220/20, H01L 21/304

(54) **COMPOSITION**

(30) Priority: 26.04.2021 JP 2021074443
(71) Applicant: Denka Company Limited, Tokyo 103-8338 (JP)
(72) Inventor: UCHIDA, HAMAGUCHI, Tometomo, Tokyo 103-8338 (JP); TANIGAWA, HOSHINO, Takako, Tokyo 103-8338 (JP); SUDO, Megumi, Tokyo 103-8338 (JP); OKUMURA, Hiromi, Tokyo 103-8338 (JP); YOSHIDA, Jun, Tokyo 103-8338 (JP)
(74) Representative: Gulde & Partner
(86) International application number: PCT/JP2022/018883
(87) International publication number: WO 2022/230874

(57) **Abstract**

Provided is a composition for temporary bonding with excellent compatibility, suitability for spin coating process, heat resistance, and suitability for various release processes. The composition comprises:
(A) a bifunctional (meth)acrylate not having a cyclic structure;
(B) a bifunctional (meth)acrylate having a cyclic structure; and
(C) a photo radical polymerization initiator.

## Description

### FIELD OF THE INVENTION

The present invention relates to a composition for temporary bonding.

### BACKGROUND OF THE INVENTION

Electronic devices are mainly composed of a substrate made of an inorganic material such as silicon, and are produced by forming an insulating film and a circuit on the surface and applying processing such as thinning by grinding. In processing, when a wafer substrate is used, a substrate having a thickness of about a few hundred microns is frequently used. Since most of the materials of the substrate is fragile and easily broken, measures to prevent breaking need to be taken particularly for thinning by grinding. A method has been taken as such measures, in which a protective tape for temporary bonding, which can be released after the completion of the step of processing, is applied to the side opposite to the side to be ground (also referred to as a rear side or back side). An organic resin film is used for the substrate of the tape, and although the tape is flexible, their strength and heat resistance are insufficient, and thus the tape is not suitable for use in steps at high temperature.

Then, systems have been proposed, which provides durability sufficient for conditions in the process for back-grinding and for forming an electrode on the back side by bonding the substrate of an electronic device to a support such as silicon or glass by an adhesive. What is important in the system is the adhesive layer for bonding the substrate and the support. The adhesive layer needs to be capable of bonding the substrate and the support without any gap, and have durability sufficient for withstanding the subsequent steps, and needs to enable the thinned wafer to be easily released from the support in the final step.

Properties required for adhesives include the following: (1) viscosity suitable for application and being Newtonian fluid (or shear rate independence of shear viscosity); (2) shear adhesive force withstanding grinding and polishing when thinning a substrate; (3) adequate hardness to avoid breaking of a substrate due to local conversion of the load of the grindstone applied to the substrate in grinding and polishing when thinning the substrate while dispersing the load in the in-plane direction to prevent local sagging of the substrate to maintain flatness; (4) heat resistance withstanding formation of insulating film and the step of soldering reflow; (5) chemical resistance withstanding thinning and resist steps; (6) easy release which enables the substrate to be easily released from the support; (7) properties of aggregation which leave no residue of the adhesive on the substrate after release; and (8) easiness of washing.

As an adhesive and a method for release thereof, proposed are a technique in which an adhesive containing a light-absorbing substance is irradiated with light at high intensity to decompose the adhesive layer so that the adhesive layer is released from the support (Patent Literature 1); and a technique in which a heat-melting hydrocarbon compound is used as an adhesive to perform bonding and release in the molten state by heating (Patent Literature 2). The problem with the former technique is that it requires an expensive apparatus such as a laser and the time for processing per substrate is long. The latter technique is convenient because the process is controlled only by heating, but since heat stability of the adhesive is insufficient at a temperature as high as more than 200°C, it can only be applied to a limited range.

A method for disassembling a bonded body is proposed, including a step for irradiating, with excimer light with a central wavelength of 172 nm or 193 nm, the bonded body formed by laminating substrates using an adhesive composition containing one or two or more (meth)acrylates having one or more (meth)acryloyl groups and curing the adhesive composition, in which at least one of the substrates transmits the excimer light (Patent Literature 3). However, Patent Literature 3 does not disclose use of light with longer wavelength. The present invention eliminates the need to use excimer light having high energy for release.

A technique of an adhesive composition for encapsulating an electronic device, which contains, as a resin composition, a polyisobutene resin and a polyfunctional (meth)acrylate and does not contain a tackifier, is disclosed (Patent Literature 4). The literature also discloses use of monofunctional (meth)acrylate as a monomer, but since the glass transition temperature of the monofunctional (meth)acrylate is not disclosed, the problem is that how to exhibit flexibility, which is required when using the resin composition as an agent for temporary bonding in the process for manufacturing an electronic device, is not clear.

A technique of an adhesive composition for encapsulating an electronic device such as an organic electroluminescent device, which contains, as a resin composition, a monofunctional (meth)acrylate, a polyfunctional (meth)acrylate and a polyisobutene polymer, is also disclosed (Patent Literature 5). However, since the glass transition temperature of the monofunctional (meth)acrylate is not disclosed, the problem is that how to exhibit flexibility, which is required when using the resin composition as an agent for temporary bonding in the process for manufacturing an electronic device, is not clear.

A resin composition for bonding substrates of a different material, which contains a monofunctional (meth)acrylate, a polyfunctional (meth)acrylate and an isobutene/maleic anhydride copolymer, and a method for bonding and disassembling the same are disclosed (Patent Literature 6). However, the polymer of Patent Literature 6 is limited in the kind by containing a component derived from maleic anhydride, and the literature does not disclose details of the method of adhesion. Patent Literature 6 does not describe their suitability for spin coating, such as viscosity.

A technique of a composite resin composition curable by active energy beams, which comprises a urethane (meth)acrylate resin having an olefin polymer structure and polyisobutylene resin is disclosed (Patent Literature 7). Furthermore, a photocurable composition comprising a component (A): a (meth)acrylate compound having a polyisobutylene structure and a component (B): a (meth)acrylamide compound, wherein 0.1 to 15 parts by mass of the component (B) based on 100 parts by mass of the component (A) is contained (Patent Literature 8). However, Patent Literatures 7 and 8 do not disclose temporary bonding application.

### PRIOR ART

### Patent Literature

[Patent Literature 1] Japanese Patent Laid-Open No. 2004-064040
[Patent Literature 2] Japanese Patent Laid-Open No. 2006-328104
[Patent Literature 3] International Publication No. WO 2011/158654
[Patent Literature 4] Japanese Patent No. 5890177
[Patent Literature 5] Japanese Translation of PCT International Application Publication No. 2009-524705
[Patent Literature 6] Japanese Patent No. 6139862
[Patent Literature 7] Japanese Patent Laid-Open No. 2017-226785
[Patent Literature 8] International Publication No. WO 2020/080309

### SUMMARY OF THE INVENTION

### TECHNICAL PROBLEM

Thus, an unsolved problem is that the conventional compositions are insufficient in curing rate, suitability for spin coating processes, heat resistant, low outgas properties under heated vacuum and release rate, and similarly insufficient particularly in suitability for UV laser release processes (release steps), when used for temporary bonding.

### SOLUTION TO PROBLEM

That is, the present invention may provide the following aspects:
Aspect 1. A composition for temporary bonding, comprising:
   (A) bifunctional (meth)acrylate not having a cyclic structure;
   (B) a bifunctional (meth)acrylate having a cyclic structure; and
   (C) a photo radical polymerization initiator.
Aspect 2. The composition for temporary bonding according to aspect 1, further comprising:
   (D) an UV absorber.
Aspect 3. The composition for temporary bonding according to aspect 1 or 2, wherein the component (A) has a molecular weight of 250 or more.
Aspect 4. The composition for temporary bonding according to any one of aspects 1 to 3, wherein the component (A) is a bifunctional (meth)acrylate not having an alkyl ether structure.
Aspect 5. The composition for temporary bonding according to any one of aspects 1 to 4, wherein the component (A) is a bifunctional (meth)acrylate having an aliphatic hydrocarbon structure or an aliphatic hydrocarbon structure having a hydroxy group, and/or having an ester structure.
Aspect 6. The composition for temporary bonding according to any one of aspects 1 to 5, wherein the component (B) is liquid having a viscosity at 23°C of 500 mPa·s or more, or solid at 23°C.
Aspect 7. The composition for temporary bonding according to any one of aspects 1 to 6, wherein the component (B) has the cyclic structure including an aromatic ring.
Aspect 8. The composition for temporary bonding according to aspect 7, wherein the component (B) has a phenol ether structure.
Aspect 9. The composition for temporary bonding according to aspect 6 or 7, wherein the component (B) has a fluorene structure.
Aspect 10. The composition for temporary bonding according to any one of aspects 1 to 9, wherein the component (C) is a photo radical polymerization initiator that generates radical with light having a wavelength of 350 nm or more.
Aspect 11. The composition for temporary bonding according to any one of aspects 1 to 10, wherein the component (C) is one or more selected from the group consisting of bis(2,4,6-trimethylbenzoyl)phenylphosphine oxide, 2,4,6-trimethylbenzoyl diphenylphosphine oxide, bis(η⁵-2,4-cyclopentadien-1-yl)-bis(2,6-difluoro-3-(1H-pyrrol-1-yl)-phenyl)titanium, 2-benzyl-2-dimethylamino-1-(4-morpholinophenyl)-butan-1-on, 2-dimethylamino-2-(4-methylbenzyl)-1-(4-morpholin-4-ylphenyl)-butan-1-on, 1-[4-(phenylthio)phenyl]-1,2-octanedione 2-O-benzoyloxym, and 1-[9-ethyl-6-(2-methylbenzoyl)-9H-carbazol-3-yl]ethanone 1-(O-acetyloxime).
Aspect 12. The composition for temporary bonding according to any one of aspects 1 to 11, comprising 0.01 to 5 parts by mass of the component (C) based on 100 parts by mass of the total amount of the components (A) and (B).
Aspect 13. The composition for temporary bonding according to any one of aspects 1 to 12, wherein a mass ratio of the component (A) to the component (B) is 5 to 95:5 to 95 based on the total 100 parts by mass of the component (A) and the component (B).
Aspect 14. The composition for temporary bonding according to any one of claims 1 to 13, further comprising:
   (E) a monofunctional (meth)acrylate.
Aspect 15. The composition for temporary bonding according to aspect 14, comprising more than 0 parts by mass and 50 parts by mass or less of the component (E) based on the total 100 parts by mass of the components (A) and (B).
Aspect 16. The composition for temporary bonding according to any one of aspects 1 to 13, not comprising a (meth)acrylate other than the component (A) and the component (B).
Aspect 17. The composition for temporary bonding according to any one of aspects 1 to 16, further comprising:
   (F) a polymer.
Aspect 18. The composition for temporary bonding according to aspect 17, comprising more than 0 parts by mass and 50 parts by mass or less of the component (F) based on the total 100 parts by mass of the components (A) and (B).
Aspect 19. The composition for temporary bonding according to any one of aspects 1 to 18, wherein a viscosity at 23°C is 100 to 10,000 mPa·s.
Aspect 20. An adhesive for temporary bonding comprising the composition for temporary bonding according to any one of aspects 1 to 19.
Aspect 21. A bonded body obtained by adhering a substrate using the adhesive for temporary bonding according to aspect 20.
Aspect 22. A cured body obtained by curing the composition for temporary bonding according to any one of aspects 1 to 19.
Aspect 23. The cured body according to aspect 22, being a single layer cured body.
Aspect 24. The cured body according to aspect 22 or 23, wherein a mass reduction reaches 2% at a temperature of 250°C or more under nitrogen atmosphere.
Aspect 25. The cured body according to any one of aspects 22 to 24, wherein a mass reduction reaches 2% at a temperature of 250°C or more under reduced pressure environment of 30 to 100 Pa.
Aspect 26. A bonded body obtained by adhering a substrate using an adhesive for temporary bonding, the adhesive comprising:
   (A) a bifunctional (meth)acrylate not having a cyclic structure;
   (B) a bifunctional (meth)acrylate having a cyclic structure; and
   (C) a photo radical polymerization initiator,
   wherein the adhesive for temporary bonding is cured with light having a wavelength of 350 nm or more, and the substrate is released by laser light having a wavelength of less than 385 nm.
Aspect 27. A method for producing a semiconductor wafer, the method comprising the steps of:
   applying an adhesive for temporary bonding according to aspect 20 to a semiconductor wafer substrate and/or a support member to bond the semiconductor wafer substrate and the support member;
   curing the adhesive for temporary bonding by irradiating light having a wavelength of 350 nm to 700 nm to obtain a bonded body; and
   irradiating the bonded body with laser light having a wavelength of less than 385 nm to release the semiconductor wafer substrate.
Aspect 28. The production method according to aspect 27, wherein the cured adhesive for temporary bonding constitutes a single layer in the bonded body.
Aspect 29. The adhesive for temporary bonding according to aspect 20 whose application is UV laser release.
Aspect 30. A cured body, comprising:
   a first cured layer comprising the composition for temporary bonding containing component (A), component (B) and component (C) and not having component (D); and
   a second cured layer comprising the composition according to aspect 2, wherein a component concentration distribution varies in the thickness direction.
Aspect 31. A cured body, comprising:
   a first cured layer obtained by curing the composition according to aspect 1 comprising component (A), component (B) and component (C); and
   a second cured layer obtained by applying an UV absorber on the first cured layer,
   wherein a component concentration distribution varies in the thickness direction.
Aspect 32. A cured body, comprising:
   a first cured layer obtained by curing the composition according to aspect 1 comprising component (A), component (B) and component (C); and
   a light heat converting (LTHC) cured layer.
Aspect 33. The cured body according to any of aspects 30 to 32 satisfying all the following conditions:
   · in a light transmittance of the cured body having a thickness of 50 µm, a light transmittance in a wavelength region of 395 nm or more among the wavelengths of a light source used for curing is 70% or more;
   · in a light transmittance of the cured body having a thickness of 50 µm, a light transmittance in a wavelength region of 350 nm or more and less than 395 nm among the wavelengths of a light source used for curing is 20% or more; and
   · in a light transmittance of the cured body having a thickness of 50 µm, a light transmittance at a wavelength (355 nm) of UV laser used for UV laser release is 1% or less.
Aspect 34. A structure, comprising:
   the cured body according to any one of aspects 30 to 33; and
   an adherend.
Aspect 35. A method for producing a structure, the method comprising the steps of:
   applying, on a wafer, a composition for temporary bonding comprising component (A), component (B) and component (C), and not having component (D) to cure partially the composition;
   applying the composition according to aspect 2 on the partially cured composition; and
   further putting a transparent substrate on the applied composition for temporary bonding to photo-cure.
Aspect 36. A method for producing a structure, the method comprising the steps of:
   applying, on a wafer, a composition for temporary bonding comprising component (A), component (B) and component (C), and not having a component (D) to cure partially as needed;
   applying the composition according to aspect 2 on a transparent substrate to cure partially as needed; and
   firmly attaching faces of the wafer and the transparent substrate on which the composition for temporary bonding has been applied and then bonding by photo-curing.
Aspect 37. A method for producing a structure, the method comprising the steps of:
   applying, on a wafer, the composition according to aspect 1 comprising component (A), component (B) and component (C), and not having component (D) to cure partially as needed,
   applying a light heat converting (LTHC) layer on a transparent substrate and drying to cure, and
   firmly attaching the face of the wafer on which the composition for temporary bonding has been applied and the face of the transparent substrate on which the LTHC layer has been applied and then bonding by photo-curing.

### ADVANTAGEOUS EFFECT OF INVENTION

The present invention may provide a composition having, for example, excellent curing rate, suitability for spin coating processes, heat resistant, low outgas properties under heated nitrogen atmosphere and reduced pressure, and release rate, and a composition for temporary bonding, which is suitable for release processes, particularly various laser release processes (e.g., UV laser release process).

### DETAILED DESCRIPTION OF THE INVENTION

The present invention will be described below. In the present description, the numerical range includes the upper limit and the lower limit unless otherwise specified. The amount and rate in the present description are the mass basis unless otherwise specified.

The monofunctional (meth)acrylate refers to a compound having one (meth)acryloyl group per a molecule. The bifunctional (meth)acrylate means a compound having two (meth)acryloyl groups per a molecule, and in the present description, the bifunctional (meth)acrylate is distinguished from other polyfunctional (meth)acrylates and monofunctional (meth)acrylates. In the present description, the polyfunctional (meth)acrylate refers to a compound having two or more (meth)acryloyl groups per a molecule, but it should be noted that the bifunctional (meth)acrylate is excluded depending on a context.

In the present description, the polymerizable compound such as (meth)acrylates means a monomer, and a compound obtained by polymerizing such a monomer is called a polymer, unless otherwise specified.

The composition for temporary bonding according to the embodiment of the present invention (hereinafter may be referred to as "a composition") comprises the following (A) to (C). The composition preferably does not comprise a (meth)acrylate other than the component (A) and the component (B).
(A) a bifunctional (meth)acrylate not having a cyclic structure;
(B) a bifunctional (meth)acrylate having a cyclic structure; and
(C) a photo radical polymerization initiator

When bifunctional (meth)acrylates are used as the component (A) and the component (B), the reactivity and crosslinkability are appropriate unlike when other (meth)acrylates are used, whereby the composition to be obtained exhibits excellent heat resistance. Considering the above, the present inventors led an idea that the combination of the component (A) not having a cyclic structure and the component (B) having a cyclic structure notably improves the performance as an agent for temporary bonding, whereby the present invention has been accomplished.

The composition according to an embodiment may not comprise (meth)acrylate other than the bifunctional (meth)acrylate. The composition according to another embodiment may comprise, as long as the effects of the present invention are not affected, (meth)acrylate other than the bifunctional (meth)acrylate (e.g., monofunctional (meth)acrylate or trifunctional (meth)acrylate), and the amount thereof may be more than 0 parts by mass and 50 parts by mass or less when the total of the component (A) and the component (B) is 100 parts by mass.

The bifunctional (meth)acrylate not having a cyclic structure of the component (A) refers to a compound which does not have an alicyclic structure or an aromatic ring structure. The (A) component may preferably be a bifunctional (meth)acrylate having a linear alkyl group, or a branched alkyl group. These alkyl groups may have a substituent, and may be, for example, a hydroxyalkyl group.

Examples of the component (A) include compounds not having an alkyl ether structure such as 1,3-butanediol di(meth)acrylate, 1,4-butanediol di(meth)acrylate, 1,6-hexadiol di(meth)acrylate, 1,9-nonanediol di(meth)acrylate, 1,10-decanediol di(meth)acrylate, neopentyl glycol di(meth)acrylate, neopentyl glycol-modified trimethylolpropane di(meth)acrylate, stearic acid-modified pentaerythritol di(meth)acrylate, tripropylene glycol di(meth)acrylate, hydroxypivalyl hydroxypivalate bis[(6-acryloyloxy)hexanoate (abbreviation: HPHPAH), di(meth)acrylate of a ε-caprolactone adduct of neopentyl glycol hydroxypivalate (e.g., product name KAYARAD HX-220, HX-620 made by Nippon Kayaku Co., Ltd).

In a preferable embodiment, the molecular weight of the component (A) may be 250 or more, more preferably 300 or more, and further preferably 500 or more, from the viewpoint of appropriately increasing a viscosity of the composition to be obtained. Although the upper limit of molecular weight of the component (A) is not particularly limited, it may be, for example, 2,000 or less, and preferably 1,000 or less, from the viewpoint of not excessively increasing a viscosity of the composition. The component (A) may have a structure induced from a branched alkyl group such as an isostearyl group, an isotetracosanyl group (e.g., 2-decyl-1-tetradecanyl group) and isotriacontanyl group (e.g., 2-tetradecyl-1-octadecanyl group) having preferably 18 to 40 carbon atoms, more preferably 18 to 32 carbon atoms. Using such a long chain, high molecular weight and highly aliphatic hydrocarbon component improves involatility, chemical resistance and heat resistance required for the composition for temporary bonding.

In a preferable embodiment, the component (A) may be di(meth)acrylate induced from polyhydric alcohol (more preferably di- or trihydric alcohol), or alkyl ester. More specifically, the component (A) may have an aliphatic hydrocarbon structure or an aliphatic hydrocarbon structure having a hydroxy group (preferably composed of a linear or branched aliphatic hydrocarbon having (meth)acryloyl groups on both terminals), or having an ester structure (preferably composed of an aliphatic ester having (meth)acryloyl groups on both terminals), or may have both properties thereof.

In a preferable embodiment, the component (A) may have a structure not having the alkyl ether structure from the viewpoint of improving heat resistance. The combination of the component (A) not having the alkyl ether structure and the component (B) having the phenol ether structure to be described later enables to obtain the improvement effect for excellent heat resistance of the composition.

The bifunctional (meth)acrylate having a cyclic structure of the component (B) is a compound having one or more cyclic structures, and the ring may be a carbon ring or a heterocyclic ring, or a combination thereof. In a preferable embodiment, the component (B) preferably has one or more aromatic rings, more preferably has more than one aromatic rings, and further preferably has fused aromatic rings (e.g., fluorene structure, naphthalene structure, indene structure, and anthracene structure), from the viewpoint of improving heat resistance.

In a preferable embodiment, when the component (B) has a spirocyclic structure, a notable effect by which excellent outgas properties and heat resistance can be compatible can be obtained while obtaining an excellent viscosity of the composition. Examples of such component (B) include bisphenol fluorene derivatives (e.g., 9,9-bis[4-(2-hydroxyethoxy)phenyl)]fluorene diacrylate), biscresol fluorene derivatives, and cycloalkane derivatives (e.g., cyclodecane derivative, cyclooctane derivative).

In a preferable embodiment, when the component (B) has a phenol ether structure, the heat resistance can be improved in the combination with the component (A) described above.

Although the molecular weight of the component (B) is not particularly limited, it may be, for example, 200 or more, more preferably 300 or more, and further preferably 500 or more, from the viewpoint of appropriately increasing a viscosity of the composition. Although the upper limit of the molecular weight of the component (B) is not particularly limited, it may be, for example, 2,000 or less, and preferably 1,000 or less, from the viewpoint of not excessively increasing a viscosity of the composition. The component (B) may be liquid having a viscosity at 23°C of 500 mPa·s or more, or solid at 23°C.

In a preferable embodiment, it is preferable that the component (B) has an aromatic ring and the number of carbon atoms at the alkyl chain part is rather short (in other words, a proportion of the aliphatic moiety to the aromatic ring may be rather small), from the viewpoint of improving outgas properties. For example, the number of carbon atoms at the alkyl chain part of the component (B) may be 20 or less, more preferably 10 or less, and further preferably 5 or less.

Examples of the component (B) include 1,3-di(meth)acryloyloxyadamantane, dicyclopentanyl di(meth)acrylate, tricyclodecane dimethanol di(meth)acrylate, 2,2-bis(4-(meth) acryloxydiethoxyphenyl) propane, 2,2-bis(4-(meth)acryloxypropoxyphenyl)propane, 2,2-bis(4-(meth)acryloxytetraethoxyphenyl)propane, isocyanuric acid ethylene oxide-modified di(meth)acrylate and di(meth)acrylates having a fluorene structure (e.g., 9,9-bis[4-(2-hydroxyethoxy]phenyl]fluorene di(meth)acrylate). The di(meth)acrylates having a fluorene structure are commercially available as A-BPEF-2 made by SHIN-NAKAMURA CHEMICAL Co., Ltd., and OGSOL GA-5060P, EA-0300, GA-5060P, and GA-2800 made by Osaka Gas Chemicals Co., Ltd.

Another example of the component (B) includes ethoxylated bisphenol A di(meth)acrylate of the following formula (1). 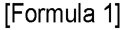 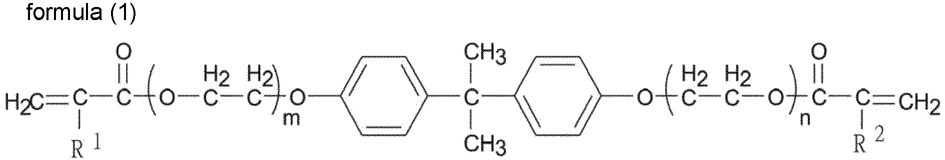 wherein R¹, R² are each independently a hydrogen atom or a methyl group, and ***m*** and ***n*** are each independently a positive number. ***m*** and n are preferably, each independently, positive numbers 1 to 10. When ***m*** = ***n*** = 1, the formula is equivalent to the 2,2-bis(4-(meth)acryloxydiethoxyphenyl)propane described above.

The mixing ratio of the component (A) and the component (B) on a mass ratio basis is preferably 5 to 95:5 to 95 (i.e., from 5:95 to 95:5), more preferably 25 to 75:25 to 75, and further preferably 33 to 67:33 to 67, based on the total 100 parts by mass thereof, from the viewpoint of suitability for spin coating process.

The photo radical polymerization initiator of the component (C) is, for example, a compound whose molecules are disconnected and divided into two or more radicals by irradiation of ultraviolet light or visible light (e.g., a wavelength of 350 nm to 700 nm, preferably 385 nm to 700 nm, more preferably 385 nm to 500 nm, and further preferably 385 nm to 450 nm).

The photo radical polymerization initiator (C) may preferably be one or more selected from an acylphosphine oxide compound, a titanocene compound, or an α-aminoalkylphenone compound from the viewpoints of reaction speed, heat resistance after curing, low outgas properties and absorption properties in a region different from a wavelength of an UV laser wavelength used for the UV laser release to be described later and an absorption wavelength region of an UV absorber used for the UV laser release. An oxime ester compound, other than the above, may be selected as the photo radical polymerization initiator for a resin composition for the temporary bonding application used to prevent breakage from bonding to heating steps for a support substrate of a substrate to be processed, which is not a layer for the UV laser release, in the composition for temporary bonding having the structure to be described later.

Examples of acylphosphine oxide compounds may include bis(2,4,6-trimethylbenzoyl)phenylphosphine oxide and 2,4,6-trimethylbenzoyldiphenylphosphine oxide. Among them, bis(2,4,6-trimethylbenzoyl)phenylphosphine oxide is particularly preferred.

Examples of titanocene compounds may include bis(η⁵-2,4-cyclopentadien-1-yl)-bis(2,6-difluoro-3-(1H-pyrrol-1-yl)-phenyl)titanium.

Examples of α-aminoalkylphenone compounds may include 2-benzyl-2-dimethylamino-1-(4-morpholinophenyl)-butan-1-on, and 2-dimethylamino-2-(4-methylbenzyl)-1-(4-morpholin-4-ylphenyl)-butan-1-on.

Examples of oxime ester compounds may include 1-[4-(phenylthio)phenyl]-1,2-octanedione 2-O-benzoyloxym, 1-[9-ethyl-6-(2-methylbenzoyl)-9H-carbazol-3-yl]etanone 1-(O-acetyloxime). Among them, 1-[9-ethyl-6-(2-methylbenzoyl)-9H-carbazol-3-yl]etanone 1-(O-acetyloxime) is preferred.

The photo radical polymerization initiator (C) may preferably be one or more selected from the group consisting of bis(2,4,6-trimethylbenzoyl)phenylphosphine oxide, 2,4,6-trimethylbenzoyl diphenylphosphine oxide, bis(η⁵-2,4-cyclopentadien-1-yl)-bis(2,6-difluoro-3-(1H-pyrrol-1-yl)-phenyl)titanium, 2-benzyl-2-dimethylamino-1-(4-morpholinophenyl)-butan-1-on, 2-dimethylamino-2-(4-methylbenzyl)-1-(4-morpholin-4-ylphenyl)-butan-1-on, 1-[4-(phenylthio)phenyl]-1,2-octanedione 2-O-benzoyloxym, and 1-[9-ethyl-6-(2-methylbenzoyl)-9H-carbazol-3-yl]ethanone 1-(O-acetyloxime).

When the composition for temporary bonding for the UV laser release step of the present invention is provided, the most preferable photo radical polymerization initiator is an acylphosphine oxide compound. Preferable acylphosphine oxide compound includes bis(2,4,6-trimethylbenzoyl)phenylphosphine oxide and/or 2,4,6-trimethylbenzoyl diphenylphosphine oxide. These photo radical polymerization initiators, in addition to excellent depth curability due to high sensitivity and photobleaching properties, have an absorption wavelength region for generating radical extending to a comparatively long-wavelength region, specifically bis(2,4,6-trimethylbenzoyl)phenylphosphine oxide has a range to a wavelength of about 440 nm, which has a significant difference from the absorption wavelength region of the UV absorber used for the UV laser release step to be described later. In other words, the degree of the UV curing inhibition by an UV absorber added is small, thereby enabling the radical polymerization to initiate with light having a longer wavelength. For this reason, the radical polymerization is enabled to initiate and cure at a comparatively high rate and efficiently even in the presence of an UV absorber.

The most preferably, the photo radical polymerization initiator may be selected from the absorbance. Specifically, the photo radical polymerization initiator may be selected from one or more compounds satisfying any one or more conditions of, when dissolved in a concentration of 0.1% by mass in a solvent having no maximum absorption in a wavelength region from 300 nm to 500 nm (e.g., acetonitrile and toluene), having an absorbance of 0.5 or more at a wavelength of 365 nm, having an absorbance of 0.5 or more at a wavelength of 385 nm, and having an absorbance of 0.5 or more at a wavelength of 405 nm. Examples of compounds satisfying such conditions may include, when dissolved in a concentration of 0.1% by mass in acetonitrile as a solvent, 1-[9-ethyl-6-(2-methylbenzoyl)-9H-carbazol-3-yl]ethanone 1-(O-acetyloxime) having an absorbance of 0.5 or more at a wavelength of 365 nm, 1-[4-(phenylthio)phenyl]-1,2-octanedione 2-O-benzoyloxym having an absorbance of 0.5 or more at wavelengths of 365 nm and 385 nm, and bis(2,4,6-trimethylbenzoyl)phenylphosphine oxide and 2,4,6-trimethylbenzoyl diphenylphosphine oxide having an absorbance of 0.5 or more at wavelengths of 365 nm, 385 nm and 405 nm.

Additionally, from the viewpoint of compatibility of curability by the photo radical polymerization initiator and UV laser releasability, bis(η⁵-2,4-cyclopentadien-1-yl)-bis(2,6-difluoro-3-(1H-pyrrol-1-yl)-phenyl)titanium having an absorption wavelength region ranging from 400 to 500 nm may also be used as the photo radical polymerization initiator.

The amount of the photo radical polymerization initiator (C) used may preferably be 0.01 to 5 parts by mass, more preferably 0.1 to 1 part by mass based on 100 parts by mass of the total amount of (A) and (B) from the viewpoints of reaction speed, heat resistance after curing and low outgas properties. When the amount of the component (C) is 0.01 parts by mass or more, sufficient curability is obtained, whereas when the amount is 5 parts by mass or less, the low outgas properties and heat resistance are unlikely to be impaired.

The UV absorber usable as the component (D) in the present composition refers to, for example, a compound whose molecules are disconnected, decomposed and vaporized by laser irradiation of ultraviolet light or visible light, and the decomposition and vaporization occurred at the interface between a support substrate (or a supporting member) and a temporary bonding agent cause the adhesive strength between the temporary bonding agent and the support substrate (the supporting member) to disappear that has been maintained until immediately before the release step.

The UV absorber (D) is preferably one or more selected from a benzotriazole compound and a hydroxyphenyltriazine compound from the viewpoints of the overlapping degree over an UV laser wavelength in the UV absorption wavelength region, UV absorption properties at the same wavelength, low outgas properties and heat resistance.

The benzotriazole compound is particularly preferably one or more selected from the group consisting of 2-(2H-benzotriazol-2-yl)-4,6-bis(1-methyl-1-phenylethyl)phenol, 2,2'-methylenebis[6-(2H-benzotriazol-2-yl)-4-(1,1,3,3-tetramethylbutyl)phenol], 2-(2H-benzotriazol-2-yl)-6-(1-methyl-1-phenylethyl)-4-(1,1,3,3-tetramethylbutyl)phenol and 2-[2-hydroxy-3-(3,4,5,6-tetrahydrophthalimide-methyl)-5-methylphenyl]benzotriazol from the viewpoints of compatibility with the resin component, UV absorption properties, low outgas properties and heat resistance.

The hydroxyphenyltriazine compound is particularly preferably one or more selected from the group consisting of 2-[4-[(2-hydroxy-3-(2'-ethyl)hexyl)oxy]-2-hydroxyphenyl]-4,6-bis(2,4-dimethylphenyl)-1,3,5-triazine, 2,4-bis(2-hydroxy-4-butyloxyphenyl)-6-(2,4-bis-butyloxyphenyl)-1,3,5-triazine and 2,4,6-tris(2-hydroxy-4-hexyloxy-3-methylphenyl)-1,3,5-triazine from the viewpoints of compatibility with the resin component, UV absorption properties, low outgas properties and heat resistance.

When the composition for temporary bonding for the UV laser release step of the present invention is provided, the most preferable UV absorber is one or more selected from the group consisting of 2,4,6-tris(2-hydroxy-4-hexyloxy-3-methylphenyl)-1,3,5-triazine, 2,4-bis(2-hydroxy-4-butyloxyphenyl)-6-(2,4-bis-butyloxyphenyl)-1,3,5-triazine, or 2,2'-methylenebis[6-(2H-benzotriazol-2-yl)-4-(1,1,3,3-tetramethybutyl)phenol]. These may be selected from a wide range of amounts to be used because of excellent compatibility with the components (A) and (B), high melting points, a comparatively low vapor pressure under a temperature condition of about 300°C or less, and may contribute to the outgas reduction from the composition for temporary bonding after curing under the temperature condition.

The most preferable UV absorber (D) may include the following absorbers selected from the UV transmittance. When the component (D) has such an UV transmittance, the effect for suitably controlling the curing and release of the composition is obtained.

When an UV absorber is dissolved in a concentration of 0.002% by mass in a solvent that does not have the maximum absorption in a wavelength of 290 to 410 nm, a transmittance is 50% or less at a wavelength of 355 nm with an optical path length of 1 cm, and a transmittance of more than 50% at a wavelength of 385 to 420 nm is preferred. Further preferably, a transmittance may be 40% or less at a wavelength of 355 nm, and a transmittance may be 60% or more at 385 to 420 nm.

Examples of the most preferable UV absorber (D) may include the following.

2-(2H-Benzotriazol-2-yl)-4,6-bis(1-methyl-1-phenylethyl)phenol (Tinuvin 900 made by BASF; ADK STAB LA-24 made by ADEKA Corporation; or EVERSORB 76, EVERSORB 234 made by Everlight Chemical Industrial Corp., molecular weight 447) having a transmittance of 20% or less at a wavelength of 355 nm with an optical path length of 1 cm, and a transmittance of 60% or more at a wavelength of 385 to 420 nm, when dissolved in a concentration of 0.002% by mass in toluene as a solvent.

2-(2H-Benzotriazol-2-yl)-6-(1-methyl-1-phenylethyl)-4-(1,1,3,3-tetramethylbutyl)phenol (Tinuvin 928 made by BASF; EVERSORB 89/89FD made by Everlight Chemical Industrial Corp., molecular weight 442) having a transmittance of 30% or less at a wavelength of 355 nm with an optical path length of 1cm, and a transmittance of 70% or more at a wavelength of 385 to 420 nm, when dissolved in a concentration of 0.002% by mass in toluene as solvent.

2-[4-[(2-Hydroxy-3-(2'-ethyl)hexyl)oxy]-2-hydroxyphenyl]-4,6-bis(2,4-dimethylphenyl)-1,3,5-triazine (Tinuvin 405 made by BASF, molecular weight 584) having a transmittance of 40% or less at a wavelength of 355 nm with an optical path length of 1 cm, and a transmittance of 90% or more at a wavelength of 385 to 420 nm, when dissolved in a concentration of 0.002% by mass in tetrahydrofuran as a solvent.

2,4-Bis(2-hydroxy-4-butyloxyphenyl)-6-(2,4-bis-butyloxyphenyl)-1,3,5-triazine (Tinuvin 460 made by BASF, molecular weight 630) having a transmittance of 10% or less at a wave length of 355 nm with an optical path length of 1 cm, and a transmittance of 80% or more at a wavelength of 385 to 420 nm, when dissolved in a concentration of 0.002% by mass in tetrahydrofuran as a solvent.

The UV transmittance of the cured body in the present description is the value obtained by reflectometric spectroscopy. Specifically, a transmittance is obtained in the following conditions using a film of a cured body having a thickness of about 50 µm prepared by being sandwiched between sheets of a PET resin with a reflectometric spectroscopy analyzer (V-650 made by JASCO Corporation).
Cell length: 10 mm
Measurement mode: T (Transmittance)
Measurement range: 450 to 200 nm
Data reading interval: 1 nm
UV/vis Band width: 2.0 nm
Response: medium
Scanning speed: 40 nm/min
Light source switching: 340 nm
Light source: D2/WI
Filter switching: Step
Correction: Base line

The amount of the UV absorber, which is the component (D), used may preferably be 0.01 to 5 parts by mass, and more preferably 0.5 to 2.5 parts by mass, based on 100 parts by mass of the total amount of (A) to (B). When the amount is 0.01 parts by mass or more, sufficient UV laser release rate is obtained, whereas when the amount is 5 parts by mass or less, the low outgas properties and heat resistance are unlikely to be impaired.

The composition having these properties may suitably be used particularly for the ion implantation in the back side step after thinning and for processes including high temperature vacuum process such as electrode formation by annealing and spattering.

The composition according to the embodiment of the present invention has a viscosity at 23°C (at atmospheric pressure) of preferably 100 to 10,000 mPa·s, more preferably 560 to 9,200 mPa·s, and further preferably 1,100 to 6,400 mPa·s.

The outgas properties of the cured body of the composition according to the embodiment of the present invention can be evaluated by the temperature at which a mass reduction reaches 2%. The cured body has the temperature at which a mass reduction reaches 2% under nitrogen atmosphere of preferably 250°C or more, more preferably 270°C or more, and further preferably 300°C or more. The cured body has the temperature at which a mass reduction reaches 2% under reduced pressure environment of 30 to 100 Pa of preferably 150°C or more, more preferably 200°C or more, and further preferably 250°C or more.

In the present description, the temperature at which a mass reduction reaches 2% can be evaluated by the combination of more than one conditions. In the related technical fields, it is known that the temperatures at which a mass reduction reaches 2% measured under different environment are not compatible. In other words, it is known that the temperature at which a mass reduction reaches 2% under a certain environment cannot be used to easily estimate such a value of another environment.

When a cured film having a thickness of 50 µm is prepared using the composition for temporary bonding of the present invention, it is preferable that one or more of the following conditions be satisfied, and it is more preferable that all be satisfied. The following conditions may be satisfied by using, for example, the UV absorber or the photo radical polymerization initiator described above.
· in the light transmittance of the cured film, a light transmittance in a wavelength region of 395 nm or more among the wavelengths of a light source used for curing is 70% or more;
· In the light transmittance of the cured film, a light transmittance in a wavelength region of 350 nm or more and less than 395 nm, preferably 385 nm or more and less than 395 nm among the wavelengths of a light source used for curing is 20% or more
· in the light transmittance of the cured film, a light transmittance at a wavelength (355 nm) of UV laser used for UV laser release is 1% or less.

When these conditions are satisfied, the compatibility of sufficiently high curing rate and UV laser release rate for practical use is enabled. Further, in addition to the compatibility of sufficiently high curing rate and UV laser release rate, a mass reduction ratio under heating condition after curing may be reduced (or the amount of outgas under high temperature vacuum may be reduced). The temporary bonding agent having these properties may suitably be used particularly for the ion implantation in the back side step after thinning and for processes including high temperature vacuum process such as electrode formation by annealing and spattering.

An antioxidant may be used for the composition of the present invention in order to maintain releasability after being exposed to high temperature. Examples of antioxidants include methyl hydroquinone, hydroquinone, 2,2-methylene-bis(4-methyl-6-t-butylphenol), catechol, hydroquinone monomethyl ether, mono-t-butyl hydroquinone, 2,5-di-t-butyl hydroquinone, p-benzoquinone, 2,5-diphenyl-p-benzoquinone, 2,5-di-t-butyl-p-benzoquinone, picric acid, citric acid, phenothiazine, t-butyl catechol, 2-butyl-4-hydroxyanisole, 2,6-di-t-butyl-p-cresol and 4-((4,6-bis(octylthio)-1,3,5-triazin-2-yl)amino)-2,6-di-t-butylphenol.

The amount of the antioxidant used is preferably 0.001 to 3 parts by mass based on 100 parts by mass of the total amount of (A) to (D). When the amount is 0.001 part by mass or more, releasability after being exposed to high temperature is surely maintained. When the amount is 3 parts by mass or less, good adhesion is obtained and uncuring does not occur.

In the composition according to an embodiment, a monofunctional (meth)acrylate may further be added as the component (E), and the amount thereof added may be more than 0 parts by mass and 50 parts by mass or less based on the total 100 parts by mass of the components (A) and (B).

Preferable examples of the component (E) may include (meth)acrylate having a linear or branched alkyl group. Examples of such a compound include ethyl (meth)acrylate, butyl (meth)acrylate, stearyl (meth)acrylate, isostearyl (meth)acrylate, nonadecyl (meth)acrylate, eicodecyl(meth)acrylate, behenyl (meth)acrylate, 2-decyl-1-tetradecanyl (meth)acrylate, and 2-tetradecyl-1-octadecanyl (meth)acrylate.

In the composition according to an embodiment, a polymer may further be added as the component (F), and the amount thereof added may be more than 0 parts by mass and 50 parts by mass or less based on the total 100 parts by mass of the components (A) and (B). The component (F) desirably has the property which does not inhibit the light transmission property of the cured body of the composition.

Examples of the component (F) may include polymers having, as a raw material, polyvinyl chloride, polyethylene, polypropylene, ethylene acetate vinyl copolymers, vinyl acetate, and modified vinyl acetate, vinyl acetate-(meth)acrylic copolymers, styrene-(meth)acrylic copolymers, vinyl acetate-(meth)acrylate copolymers, (meth)acrylic-silicone copolymers, (meth)acrylic-urethane copolymers, natural rubbers, and synthetic rubbers, but it is preferable to add those having a glass transition temperature of 300°C or less (polyisobutene, and the like) only in a small amount (e.g., 5 parts by mass or less based on the total 100 parts by mass of the components (A) and (B)), and further preferably not to add at all, from the viewpoint of improving the heat resistance.

Known methods of application such as spin coating, screen printing and coaters may be used as the method for applying the composition. The composition of the present invention has a viscosity of preferably 100 mPa·s or more, more preferably 1,000 mPa·s or more, and most preferably 2,000 mPa·s or more from the viewpoints of coating properties and operationability. The composition of the present invention has a viscosity of preferably 10,000 mPa·s or less, more preferably 5,000 mPa·s or less, and most preferably 4,000 mPa·s or less from the viewpoints of coating properties and operationability. When the viscosity is 100 mPa·s or more, coating properties, in particular coating properties in spin coating are excellent. When the amount is 10,000 mPa·s or less, operationability is excellent.

Spin coating process refers to a method in which, for example, a liquid composition is dropped on a substrate and the substrate is rotated at a pre-determined rotational speed to coat the surface of the substrate with the composition. Spin coating enables high quality coating to be produced efficiently.

The composition of the present invention may be used as a resin composition for temporary bonding, an adhesive for temporary bonding, an adhesive sheet or an adhesive for temporary bonding for manufacturing an electronic device. In the present specification, the composition for temporary bonding, the resin composition for temporary bonding and the adhesive for temporary bonding may collectively be called the temporary bonding agent.

When a substrate to be processed and an optically transparent support substrate (or a support) are bonded using the composition of the present invention, it is preferable that the substrates be irradiated with visible light or ultraviolet light (wavelength or central wavelength 365 to 405 nm) so that the amount of energy is 1 to 20,000 mJ/cm². An amount of energy of 1 mJ/cm² or more provides sufficient adhesiveness, and an amount of energy of 20,000 mJ/cm² or less provides excellent productivity, generates few decomposition products from photo radical polymerization initiator, and suppresses generation of outgas. The amount of energy may preferably be 1 to 10,000 mJ/cm² from the viewpoints of productivity, adhesiveness, low outgas properties and easy release.

Although the substrate to be bonded using the composition of the present invention is not particularly limited, it is preferable that at least one substrate be a transparent substrate which transmits light. Examples of transparent substrates include inorganic substrates such as crystal, glass, quartz, calcium fluoride and magnesium fluoride, and organic substrates such as plastic. Of them, inorganic substrates are preferred because they are versatile and provide high effects. Of the inorganic substrates, one or more selected from glass and quartz are preferred.

In an embodiment, the composition of the present invention is photo-curable, and the cured body provided by such a composition has excellent heat resistance and releasability. In an embodiment the amount of outgas from the cured body of the composition of the present invention is small even when exposed to high temperature, and thus the cured body is suitable for bonding, encapsulating and coating various optical parts, optical devices and electronic parts. The composition of the present invention is suitable for applications in which wide-ranging durability such as solvent resistance, heat resistance and adhesiveness, is required, and in particular, suitable for processes for manufacturing semiconductors.

The cured body of the composition of the present invention may be used in a process having a wide temperature range from room temperature to high temperature. The temperature of heating in a process may preferably be 350°C or less, more preferably 300°C or less, and most preferably 250°C or less. The bonded body bonded using the adhesive for temporary bonding of the present invention has high shear adhesive strength and may withstand the step for thinning and the like, and may be easily released after the step for heating, such as forming an insulating film. When used at high temperature, the cured body of the composition of the present invention may be used in a process at a high temperature of, for example, preferably 200°C or more, and more preferably 250°C or more.

Furthermore, in an embodiment of the present invention, a bonded body to which a substrate is bonded using an adhesive for temporary bonding is obtained, and the effect is obtained for releasing the substrate by applying an external force to the bonded body. For example, it may be released by inserting a blade, sheet or wire.

Furthermore, in an embodiment of the present invention, a bonded body to which a substrate is bonded using an adhesive for temporary bonding is obtained, and the effect is obtained for releasing the substrate by irradiating the entire surface by scanning with UV laser or IR laser from the side of the optically transparent support of the bonded body.

### Method for producing thin wafer

The embodiment of the present invention may also provide a method for producing a thin wafer. The production method comprises using the composition for temporary bonding or the adhesive for temporary bonding (hereinafter may be referred to as an adhesive or a temporary bonding agent) described above as an adhesive layer between a wafer with a semiconductor circuit and the like and a support. The method for producing a thin wafer of the present invention comprises the following steps (a) to (e).

### Step (a)

The step (a) is a step in which, when bonding a circuit-bearing surface of a wafer having the circuit-bearing surface on the front and a circuit-free surface on the back to a support with an adhesive, the adhesive is applied to the support or the wafer with the circuit by spin coating to bond another support or wafer with circuit in vacuum.

The wafer having a circuit-bearing surface and a circuit-free surface has the circuit-bearing surface on one side and the circuit-free surface on the other side. Generally the present invention can be applied to semiconductor wafers. Examples of semiconductor wafers include not only silicon wafer but also gallium nitride wafer, lithium tantalate wafer, lithium niobate wafer, silicon carbide wafer, germanium wafer, gallium-arsenide wafer, gallium-phosphorus wafer and gallium-arsenide-aluminum wafer. The thickness of the wafer is not particularly limited, and is preferably 600 to 800 µm, and more preferably 625 to 775 µm. A transparent substrate which transmits light may be used as a support.

### Step (b)

The step (b) is for photo-curing the adhesive. It is preferable that after forming the processed wafer (laminated substrate), the wafer be irradiated with light in a region of visible light or ultraviolet light (wavelength or central wavelength 365 nm to 405 nm) with the amount of energy of 1 to 20,000 mJ/ cm². An amount of energy of 1 mJ/ cm² or more provides sufficient adhesiveness, and an amount of energy of 20,000 mJ/ cm² or less provides excellent productivity, generates few decomposition products from photo radical polymerization initiator, and suppresses generation of outgas. The amount of energy is more preferably 1,000 to 10,000 cm²from the viewpoints of productivity, adhesiveness, low outgas properties and easy release.

The composition may be cured by using black light, UV-LED and visible light-LED as a light source and, for example, the following light sources may be used. For the black light, light including a component having a wavelength of 350 nm or more, and preferably 385 nm or more is preferably used regardless of the central wavelength thereof. When a wavelength range is described in the present description, it should be decided whether or not the range is included in the range based on whether or not the central wavelength is included in the range.
· Black light (central wavelength 365 nm, intensity 10 mW/cm², TUV-8271 made by TOYO ADTEC)
· UV-LED (wavelength 385±5 nm, intensity 350 mW/cm² (condition: work distance from mirror unit edge 20 mm), H-4MLH200-V2-1S19 + specially designed mirror unit made by HOYA CORPORATION)
· UV-LEDz (wavelength 395±5 nm, intensity 375 mW/cm² (condition: work distance from mirror unit edge 20 mm), H-4MLH200-V3-1S19 + specially designed mirror unit made by HOYA CORPORATION)
· UV-LED (wavelength 405±5 nm, intensity 400 mW/cm² (condition: work distance from mirror unit edge 20 mm), H-4MLH200-V4-1S19 + specially designed mirror unit made by HOYA CORPORATION)
· UV-LED (central wavelength 405 nm, intensity 10 mW/cm², HLDL-120V0-NWPSC made by CCS Inc.)
· Visible-LED (wavelength 451±5 nm, intensity 550 mW/cm² (condition: work distance from mirror unit edge 10 mm), HLDL-155VL450-PSC made by CCS Inc.)
· Visible-LED (wavelength 492±5 nm, intensity 400 mW/cm² (condition: work distance from mirror unit edge 10 mm), HLDL-155BG-PSC made by CCS Inc.)

In a preferable embodiment, UV-LED or visible-LED with a low integrated light intensity (only short irradiation time is required) may be a light source rather than black light with a high integrated light intensity generally due to a broad irradiation wavelength, likely extending the irradiation time. More specifically, the use of an LED light source having a narrow irradiation wavelength enables the temporary bonding in a short time, thereby consequently providing an effect for saving time required for the manufacturing step.

### Step (c)

The step (c) is for grinding and/or polishing the circuit-free surface of the wafer bonded to the support, in other words, the step for grinding the back side of the processed wafer obtained by lamination in the step (a) to reduce the thickness of the wafer. The thinned wafer has a thickness of preferably 10 to 300 µm, and more preferably 30 to 100 µm. The method of grinding/polishing the back side of the wafer is not particularly limited and a known grinding/polishing method may be used. It is preferable that the wafer be ground while pouring water to the wafer and the grindstone (grindstone with a diamond blade and the like) to cool them.

### Step (d)

The step (d) is for processing the processed wafer whose circuit-free surface has been ground/polished; in other words, processing the circuit-free surface of the processed wafer which has been thinned by grinding/polishing the back side. The step includes various processes used at the wafer level, such as formation of electrodes, formation of metal wiring and formation of protective film. More specifically, it includes conventionally known processes such as metal sputtering for forming an electrode and the like, wet etching for etching the metal-sputtering layer, formation of patterns by application of resist for preparing mask for forming metal wiring, exposure and development, removal of resist, dry etching, formation of metal plating, silicon etching for forming TSV and formation of oxide film on the surface of silicon.

### Step (e)

The step (e) is a release step. In the step, the wafer processed in the step (d) is released from the processed wafer. For example, the step is for releasing the wafer from the processed wafer before dicing after doing various processing on the thinned wafer. At that stage, dicing tape may be attached in prior to the release to the side which has been thinned and processed. The release step is usually carried out in a condition of a relatively low temperature of room temperature to about 60°C. For the release step, any of a known UV laser release step, IR laser release step or mechanical release step may be employed. Preferably, UV laser release step may be employed.

The UV laser release step is a step for, for example, irradiating the entire surface of a processed wafer with UV laser so that the wafer is scanned with the laser linearly and reciprocally from the end of an optically transparent support in the direction of a tangent to decompose the adhesive layer with the energy of the laser to release the wafer. Such a release step is disclosed in, for example, Japanese Translation of PCT International Application Publication No. 2019-501790, and Japanese Translation of PCT International Application Publication No. 2016-500918. The composition for temporary bonding of the present invention comprising particularly the component (D) and satisfying preferable requirements of the component (C) and/or the component (D) is suitable particularly for the UV laser release step.

The IR laser release step is a step for, for example, irradiating the entire surface of a processed wafer with IR laser so that the wafer is scanned with the laser linearly and reciprocally from the end of an optically transparent support in the direction of a tangent to heat and decompose the adhesive layer with the energy of the laser to release the wafer. Such a release step is disclosed in, for example, Japanese Patent 4565804. To perform the IR laser release step, a light heat converting layer (e.g., "LTHC; Light-To-Heat-Conversion release coating" manufactured by 3M) which absorbs IR laser light and converts it to energy may be provided between a layer of temporary bonding agent and a glass support. When LTHC made by 3M is used, LTHC is, for example, spin-coated and cured on the glass support, and the layer of temporary bonding agent, which is spin-coated on wafer, is laminated on the glass support on which the LTHC layer has been formed, and they may be UV cured. The method for carrying out the IR laser release step using LTHC made by 3M is disclosed, for example, in Japanese Patent No. 4565804 described above.

The mechanical release step includes, for example, horizontally fixing the processed wafer with the wafer facing downward so as to insert a blade into the end of the interface of the processed wafer to make an opening between the wafer and the support and after inserting the blade, applying upward stress to the support and/or the blade on the upper side to extend the opening to release the wafer from the support. Such a release step is disclosed in, for example, Japanese Patent No. 6377956 and Japanese Patent Laid-Open No. 2016-106404.

Any of the above release methods may be used for releasing the composition according to the embodiment of the present invention. It is preferable that in these cases, one end of the wafer of the processed wafer or the support be horizontally fixed and then a blade be inserted thereinto, or the periphery of the adhesive layer be swollen using a solvent (e.g., aliphatic or an aromatic hydrocarbon solvents such as pentane, hexane, heptane, octane, nonane, decane, benzene, toluene, xylene and mesitylene) to cause release, and the other end be lifted at a certain angle in the horizontal direction. Although these methods are usually performed at room temperature, heating at an upper limit of about 90°C is also preferred. When laser is used, YAG laser or YVO₄ laser is preferably used.

When the above step (e) for releasing the processed wafer from a support is a mechanical release step, it is preferable that the step further may include the steps of:
(f) adhering dicing tape on the wafer surface of a processed wafer,
(g) vacuum sucking the side of the dicing tape to the suction surface, and
(h) releasing the support from the processed wafer at a temperature of the suction surface ranging from 10 to 100°C. This facilitates release of the support from the processed wafer and makes it easier to perform the subsequent dicing step.

When the release is performed with UV laser or IR laser, the production method may preferably further comprise the steps of:
(i) setting and fixing a processed wafer at a horizontal position with an optically transparent support facing upward preferably via dicing tape, and
(j) scanning of the entire surface of the processed wafer with laser from the side of the support.
This facilitates release of the support from the processed wafer and makes it easier to perform the subsequent dicing step.

The step (e) for releasing the processed wafer from the support with UV laser or IR laser may perform a subsequent step of:
(k) removing the temporary bonding agent remaining on the surface of the wafer.

The method for removing the temporary bonding agent includes a method in which the thinned side is vacuum sucked on the suction surface, while an adhesive tape such as dicing tape is attached to the entire surface of the other side on which the temporary bonding agent is remaining to peel the temporary bonding agent together with the tape, and a method in which the wafer is immersed in a solvent (e.g., aliphatic or aromatic hydrocarbon solvents such as pentane, hexane, heptane, octane, nonane, decane, benzene, toluene, xylene and mesitylene) and the adhesive layer is swollen to cause release. Of these methods, the tape release method is preferable from the viewpoints of fewer numbers of steps and short time required.

The wafer after the temporary bonding agent is removed may be sent to the subsequent step without washing the surface. It is preferable that when the surface is to be washed, the method may comprises:
a step (I) for washing the wafer from which the support and the temporary bonding agent have been removed using a solvent (e.g., aliphatic or aromatic hydrocarbon solvents such as pentane, hexane, heptane, octane, nonane, decane, benzene, toluene, xylene and mesitylene) be further performed with the circuit-bearing surface facing upward.

A part of the adhesive (temporary bonding agent) may remain on the circuit-bearing surface of the wafer from which the temporary bonding agent has been removed in the step (k). While it is preferable that the support released be washed and reused, residue of adhesive may have been adhered on the surface of the support. Examples of methods for removing these residues of adhesive include a method in which the wafer and the support are immersed in a solvent (e.g., aliphatic or aromatic hydrocarbon solvents such as pentane, hexane, heptane, octane, nonane, decane, benzene, toluene, xylene and mesitylene), and the residual adhesive is swollen to cause release.

In an embodiment, when obtaining a cured body by curing the composition, various techniques as follows may be employed.

In the first technique, a layer of the composition for temporary bonding comprising the components (A) to (C) is cured, thereby enabling to obtain a single layer cured body.

The second technique is a technique in which a first layer comprising a composition for temporary bonding having a component (A), a component (B), and a component (C) and does not have a component (D) and a second layer comprising a composition for temporary bonding having the components (A) to (D) are respectively prepared and cured, thereby obtaining a cured body having an integrated single layer or multilayer (multiple layers). This cured body is preferable in the aspects that a component concentration distribution in the thickness direction varies or a component concentration distribution varies in the upper side and the lower side in the thickness direction of the cured body. The variation in a component concentration distribution may be confirmed by quantitatively determining UV transmittances of the both sides of the cured body by the reflectometric spectroscopy described above. This technique may provide the effect for realizing the optimum curing by combining layers with different light transmission properties. In the curing described above, black light and UV-LED may be used as a light source (the same applies to the following techniques). Examples of black light include TUV-8271 (central wavelength 365 nm, intensity 10 mW/cm²) made by TOYO ADTEC. Examples of UV-LED include H-4MLH200-V2-1S19 + specially designed mirror unit (wavelength 385±5 nm, intensity 350 mW/cm², condition: scan pitch from mirror unit edge 20 mm) made by HOYA CORPORATION, H-4MLH200-V3-1S19 + specially designed mirror unit (wavelength 395±5nm, intensity 375 mW/cm², condition: work distance from mirror unit edge 20 mm) made by HOYA CORPORATION, and H-4MLH200-V4-1S19 + specially designed mirror unit (wavelength 405±5 nm, intensity 400 mW/cm², condition: work distance condition: work distance 20 mm) made by HOYA CORPORATION.

The third technique also enables to obtain a cured body having at least a partially integrated single layer by applying (e.g., application by spin coat) a component (D) on a cured layer comprising a component (A), a component (B) and a component (C). In this case, a component concentration distribution varies in the thickness direction of the cured body. The component concentration distribution may quantitatively be determined by reflectometric spectroscopy of each layer to be determined as described above. This technique may provide the effect for precisely controlling UV absorption properties.

As the fourth technique, a multilayer cured body may be obtained by putting a layer of a commercial LTHC agent (light heat converting agent) on a layer comprising a component (A), a component (B) and a component (C) and curing. This may provide an effect for easily obtaining a cured body.

The cured body obtained by the techniques described above may be provided as a structure in combination with an adherend.

The method for producing the structure described above include various examples. For example, the first production method may comprise a step for applying a first composition for temporary bonding having a component (A), a component (B) and a component (C), and not having a component (D) on a wafer to cure partially, a step for applying a second composition for temporary bonding comprising the components (A) to (D) on the partially cured composition for temporary bonding, and a step for further putting a transparent substrate on the applied second composition for temporary bonding to photo-cure.

The second method for producing the structure may comprise a step for applying a first composition for temporary bonding having a component (A), a component (B) and a component (C), and not having a component (D) on a wafer to cure partially as needed, a step for applying a second composition for temporary bonding comprising the components (A) to (D) on a transparent substrate to cure partially as needed, and a step for firmly attaching faces of the wafer and the transparent substrate respectively on which the composition for temporary bonding has been applied and then bonding by photo-curing.

The third method for producing the structure may comprise a step for applying a composition for temporary bonding having a component (A), a component (B) and a component (C), and not having a component (D) on a wafer to cure partially as needed, a step for applying a LTHC layer on a transparent substrate and drying to cure, and a step for firmly attaching the face of the wafer on which the composition for temporary bonding has been applied and the face of the transparent substrate on which the LTHC layer has been applied and then bonding by photo-curing.

Apart from the composition for temporary bonding described above, the same composition as used for the composition for temporary bonding of the present invention may also be used as a raw material of a light heat converting (LTHC) layer which absorbs IR laser light and converts it to energy disclosed in Japanese Patent No. 4565804. Using the present composition as a component for the light heat converting (LTHC) layer may improve heat resistance thereof.

Another aspect of the present invention provides a method for producing a semiconductor wafer comprising a step for applying an adhesive for temporary bonding to a semiconductor wafer substrate and/or a support member to bond the semiconductor wafer substrate and the support member, a step for curing the adhesive for temporary bonding by irradiating with light having a wavelength of 350 nm to 700 nm (preferably 385 to 700 nm, more preferably 385 to 500 nm, further preferably 385 to 450 nm) to obtain a bonded body, and a step for irradiating the bonded body with laser light having a wavelength of less than 385 nm (preferably laser light having a wavelength of 200 nm or more and a wavelength of less than 385 nm) to release the semiconductor wafer substrate. The present production methods have both steps for curing and releasing performed at room temperature, do not need to heat or cool a member, generally do not need to use a solvent and the like, and are simple with short cycle time (takt time), hence beneficial.

Further, the cured adhesive for temporary bonding may constitute a single layer in the bonded body. It is preferable to simplify steps and reduce cycle time (takt time).

In a preferable embodiment, the composition comprises the preferable photo radical polymerization initiator component (C) and the UV absorber component (D) described above, thereby enabling a fast curing rate and a fast release rate to be compatible even if the adhesive for temporary bonding is a single layer. Further, it is possible to notably reduce an uncured UV curable monomer component remaining on the cured body when UV-curing the adhesive for temporary bonding, thereby enabling heat resistance of the cured body to be improved and a volatile matter under vacuum to be reduced. More specifically, for example, it is possible to increase the temperature at which the mass reduction by heating reaches 2% when measuring Tg/DTA of the cured body. The adhesive for temporary bonding having a high heat resistance of the cured body and a reduced volatile matter under vacuum is extremely useful for the recent semiconductor manufacturing process.

### EXAMPLES

Hereinafter the present invention will be described in more detail with reference to Examples, but the present invention is not limited thereto.

Experiments were carried out at 23°C and a humidity of 50% unless otherwise specified. The curable resin compositions (hereinafter may be referred to as a liquid resin composition) having the composition (unit is the part by mass) shown in Tables 1a, 1b, and 2 were prepared and evaluated. The following compounds were selected as the components of the curable resin compositions described in Experimental Examples.

### Composition

The following compounds were selected as the bifunctional (meth)acrylate not having a cyclic structure (A).
Hydroxypivalyl hydroxypivalate bis[6-acryloyloxy)hexanoate (hereinafter may be abbreviated as "HPHPAH"; made by Sigma-Aldrich Co. LLC, molecular weight 541)
Diacrylate of a ε-caprolactone adduct of neopentyl glycol hydroxypivalate ("KAYARAD HX-220" made by Nippon Kayaku Co., Ltd., hereinafter may be abbreviated as "HX-220", molecular weight 541, the number of carbon atoms = 28)
Diacrylate of a ε-caprolactone adduct of neopentyl glycol hydroxypivalate ("KAYARAD HX-620" made by Nippon Kayaku Co., Ltd., hereinafter may be abbreviated as "HX-620", molecular weight 783, the number of carbon atoms = 40)
1,4-Butanediol diacrylate ("Viscoat#195" made by OSAKA ORGANIC CHEMICAL INDUSTRY LTD., hereinafter may be abbreviated as "#195", molecular weight 198, the number of carbon atoms = 10)

The following compounds were selected as the bifunctional (meth)acrylate having a cyclic structure (B).
Ethoxylated bisphenol A diacrylate (2,2-bis(4-acryloxydiethoxyphenyl)propane, solid, molecular weight 424, in the formula (1), R¹, R² are a hydrogen atom, m and n are 1. Hereinafter may be abbreviated as "BPE")
Diacrylate having a fluorene structure (9,9-bis[4-(2-hydroxyethoxy)phenyl]fluorene diacrylate, "NK ESTER A-BPEF-2" made by SHIN-NAKAMURA CHEMICAL Co., Ltd., hereinafter may be abbreviated as "A-BPEF-2", solid, molecular weight 546)

The following compound was selected as the photo radical polymerization initiator (C).
Bis(2,4,6-trimethylbenzoyl)phenylphosphine oxide ("Irgacure 819" made by BASF)
1-[9-Ethyl-6-(2-methylbenzoyl)-9H-carbazol-3-yl]ethanone 1-(O-acetyl oxime) ("Irgacure OXE-02" made by BASF, hereinafter may be abbreviated as "OXE-02")

The following compounds were selected as the UV absorber (D).
2,4-Bis(2-hydroxy-4-butyloxyphenyl)-6-(2,4-bis-butyloxyphenyl)-1,3,5-triazine ("Tinuvin 460" made by BASF, molecular weight 630)

The following compound is selected as the antioxidant.
4-((4,6-Bis(octylthio)-1,3,5-triazin-2-yl)amino)-2,6-di-t-butylphenol ("IRGANOX 565" made by BASF)

### Preparation of liquid sample

Materials were mixed while heating at 80°C to prepare a homogeneous mixture.

### Preparation of cured sample using 365 nm UV-LED

The liquid resin composition homogenized by the above mixing was sandwiched between PET films, pressed out to make the thickness down to 50 µm (sample for measuring elastic modulus to be described later was 0.5 mm), and cured in a condition of an integrated light intensity of 5,000 mJ/cm² to prepare a cured body. For curing, UV-LED (central wavelength 365 nm, intensity 100 mW/cm², HLDL-120U6-NWPSC made by CCS Inc.) was used.

### Preparation of cured sample using 405 nm UV-LED

The liquid resin composition homogenized by the above mixing was sandwiched between PET films, pressed out to make the thickness down to 50 µm (sample for measuring elastic modulus to be described later was 0.5 mm), and cured in a condition of an integrated light intensity of 5,000 mJ/cm² to prepare a cured body. For curing, UV-LED (central wavelength 405 nm, intensity 100 mW/cm², HLDL-120V0-NWPSC made by CCS Inc.) was used.

Step for preparing sample for evaluating suitability for UV laser release process:
The liquid resin composition prepared was spin-coated on an 8-inch silicon wafer (diameter 200 mm × thickness 0.725 mm) in an automatic wafer bonder in a condition of having a thickness of 50 µm, and then bonded to an 8-inch glass wafer (diameter 201 mm × thickness 0.7 mm) in the same apparatus under a reduced pressure condition of 10 Pa. After bonding, the liquid resin composition was cured using any of the above UV light sources from the glass wafer side to obtain a bonded body. Subsequently, the side of the silicon wafer of the obtained bonded body was thinned down to a thickness of 50 µm by grinding and polishing and then heated for 1 hour under high temperature and reduced pressure environment of 300°C, 20 Pa.

### Evaluation

Compatibility of materials of liquid resin composition ("Compatibility of materials", "Absorbance" in the Tables 1a, 1b and 2):

The homogenized composition for temporary bonding by the above mixing was cooled to 23°C, and whether the homogeneous state was kept or not was observed. The absorbance (OD660) of a sample at a wavelength of 660 nm, which was put in a cell having a width of 10 mm in the direction of optical path length was measured using Ultraviolet-visible spectrophotometer V-650 made by JASCO Corporation. Those having an absorbance of less than 0.1 were rated as compatible and pass, and those having an absorbance of 0.1 or more and in which non-homogeneity such as phase separation was visually observed were rated as incompatible and failure. The absorbance is preferably less than 0.1 from the viewpoint of compatibility. The evaluations thereafter were omitted for Examples rated as "Failure". The same applies to below.

Viscosity ("Suitability for spin coating process," "Viscosity" in Tables 1a, 1b and 2):
The viscosity of the liquid resin compositions which were kept homogeneous at 23°C in the above "Compatibility of materials" was measured to evaluate suitability for spin coating on the upper surface of the substrate which is assumed to be used in an actual process. The viscosity was measured in a temperature condition of 23°C using Rheometer MCR 302 made by Anton-Paar and cone plate CP 50-2. Those having a shear viscosity at 1 s⁻¹ of 1,000 mPa·s or more and less than 4,000 mPa·s were rated as excellent, those having a shear viscosity at 1 s⁻¹ of 4,000 mPa·s or more and 10,000 mPa·s or less, or those having a shear viscosity at 1 s⁻¹ of 100 mPa·s or more and less than 1,000 mPa·s were rated as pass, and those having a shear viscosity at 1 s⁻¹ of more than 10,000 mPa·s or more or less than 100 mPa·s were rated as failure. The viscosity is preferably 100 to 10,000 mPa·s from the viewpoint of suitability for the spin coating process. The evaluations thereafter were omitted for Examples rated as "Failure". The same applies to below.

Temperature at which mass of cured body is reduced by 2% by heating under nitrogen atmosphere ("Heat resistance 1", "Temperature at which mass of cured body is reduced by 2% by heating under nitrogen atmosphere" in Tables 1a, 1b, and 2):
Using 2 to 10 mg of the resulting cured body, the mass reduction ratio of the resulting cured body by heating was measured by using a simultaneous thermogravimetry/differential thermal analyzer "TG-DTA STA-2500" made by NETZSCH Japan K.K. while increasing temperature at a temperature increase rate of 10°C/minute from 30°C to 600°C under nitrogen atmosphere. The temperature at which the mass of the cured body is reduced by heating by 2% is shown. Those whose mass was reduced by 2% at the point when the temperature reached 300°C or more were rated as excellent; those whose mass was reduced by 2% at the point when the temperature reached 250°C or more and less than 300°C were rated as good; those whose mass was reduced by 2% at the point when the temperature reached at 200°C or more and less than 250°C were rated as pass; and those whose mass was reduced by 2% at the point before the temperature reached 290°C were rated as failure.

Temperature at which mass is reduced by 2% by heating under reduced pressure ("Heat resistance 2", "Temperature at which mass of cured body is reduced by 2% by heating under reduced pressure" in Tables 1a, 1b, and 2):
Using 2 to 5 mg of the resulting cured body, the mass reduction ratio of the resulting cured body by heating was measured by using a simultaneous thermogravimetry/differential thermal analyzer "TG-DTA STA-2500" made by NETZSCH Japan K.K. while increasing temperature at a temperature increase rate of 10°C/minute from 30°C to 600°C under reduced pressure of 30 to 100 Pa. The temperature at which the mass of the cured body is reduced by heating by 2% is shown. Those whose mass was reduced by 2% at the point when the temperature reached 250°C or more were rated as excellent; those whose mass was reduced by 2% at the point when the temperature reached 200°C or more and less than 250°C were rated as good; those whose mass was reduced by 2% at the point when the temperature reached at 150°C or more and less than 200°C were rated as pass; and those whose mass was reduced by 2% at the point before the temperature reached 150°C were rated as failure. The temperature at which the mass of the cured body is reduced by heating by 2% is preferably 150°C or more, and more preferably 250°C or more from the viewpoint of suitability for high temperature steps for manufacturing a semiconductor.

Pressure changes under reduced pressure conditions ("Outgas properties", "Pressure at the time of reaching 300°C" in Table 4):
On a 4-inch silicon wafer, a φ 4-inch sheet obtained by cutting out PTFE having a thickness of 50 µm to φ 3 inches was placed, a liquid resin composition was applied to the cut-out part, the PET sheet and a 4-inch wafer were laminated and cured under conditions of an LED integrated light intensity of 5,000 mJ/cm² (central wavelength 405 nm, intensity 100 mW/cm²). The surface of the 4-inch glass wafer was irradiated with the LED. After curing, the PET film was peeled, the laminate of the wafer and the resin composition was cut out to φ 1 cm to prepare a sample. Using a heated gas extraction/mass spectrometer, TE-360S type, in vacuum, under reduced pressure condition of 1 to 2 × 10⁻⁶ Pa, temperature was increased at a temperature increase rate of 10°C/minute from 50°C to 600°C, and a pressure rise by an outgas was measured. Those maintained a pressure of less than 5 × 10⁻⁶ Pa at the point when the temperature reached 300°C were rated as excellent, those maintained a pressure of at 5 × 10⁻⁶ or more and less than 1 × 10⁻⁵ Pa were rated as good, those maintained a pressure of 1 × 10⁻⁵ or more and less than 5 × 10⁻⁴ Pa were rated as pass, and those reached a pressure of 5 × 10⁻⁴ Pa or more were rated as failure. The pressure is preferably less than 5 × 10⁻⁴ Pa, and more preferably less than 5 × 10⁻⁶ Pa from the viewpoint of suitability for high temperature steps for manufacturing a semiconductor.

Adhesiveness at high temperature ("Adhesiveness in high temperature condition (300°C, 1h, reduced pressure 20 Pa)," "Width of color change in periphery" and "peeling due to heating" in Tables 1a, 1b and 2):
A 4-inch silicon wafer (diameter 10 cm × thickness 0.47 mm) was laminated with a 4-inch glass wafer (diameter 10 cm × thickness 0.7 mm) using the liquid resin composition prepared. When laminating, the thickness of the resin composition was adjusted by using a mixture of the temporary bonding agent to which 0.1% by mass of silica particles made by UBE Exsymo Co., Ltd. (product name HIPRESICA TS N3N, average particle size 50 µm) were added and mixed. After laminating, the composition was cured in a condition of an LED integrated light intensity of 5,000 mJ/cm² (central wavelength 405 nm, intensity 100 mW/cm²) to prepare a sample for evaluating adhesiveness in high temperature and reduced pressure conditions. The adhesive was applied to the entire surface of lamination. The surface of the 4-inch glass wafer was irradiated with LED. The sample prepared was put on a hot plate in a vacuum hot plate chamber made by MSA Factory Co., Ltd. with the 4-inch silicon wafer facing downward and heated to observe the width of the region of color change in the periphery in the direction of the center of the wafer, and occurrence of peeling which could be visually observed from the side of the glass. Under the reduced pressure of 20 Pa, the temperature of the hot plate was 300°C and the time of continuing heating was 1 hour. In "Adhesiveness in high temperature condition (300°C, 1h, reduced pressure 20 Pa)" in Tables 1a, 1b, 2, those without peeling and color change were rated as excellent, those with a width of the region of peeling or color change in the periphery in the direction of the center of 5 mm or less were rated as good, those with such a width of more than 5 mm and 10 mm or less were rated as pass, and those with peeling and color change more than that were rated as failure.
(1) Suitability for UV laser release process ("UV laser releasability", "Minimum value of time required for achieving complete release" in Tables 1a, 1b and 2, and "UV laser irradiation conditions" in Table 3):
   From the glass support side of the obtained 8-inch sample, an area of 210 mm-square on which the sample was fixed in the center was irradiated by scanning the entire surface of the sample with UV laser. Each condition shown in Table 3 as UV laser irradiation condition was sequentially applied to Examples in Table 1a, 1b respectively for the evaluations. UV laser QLA-355 made by Quark Technology Co., Ltd. was used in the conditions shown under Condition Number 9 of Table 3 (Table 3 shows trials to investigate optimum conditions) at an output of 9.3 W, a pulse energy of 235 µJ, an energy density of 11968 mJ/cm², a frequency of 40 kHz, a beam diameter (spot diameter) of 50 µm, and a scan pitch of 50 µm with a scan speed of 20 m/s. For releasability after irradiation, those in a state where the adhesive strength disappeared so completely that the glass support slides (or moves) freely on the silicon wafer (adhesive strength = 0) were defined as complete release, and suitability for the UV laser release process was evaluated based on the minimum value of time required for the UV laser irradiation process for achieving the state of complete release. Those having the minimum value of time required of less than 15 seconds were rated as excellent, those with 15 seconds or more and less than 30 seconds were rated as good, those with 30 seconds or more and less than 60 seconds were rated as pass, and those with 60 seconds or more were rated as failure.

**[Table 1a]**

| | | | | Example 1 | Example 2 | Example 3 | Example 4 | Example 5 | Example 6 | Example 7 |
|---|---|---|---|---|---|---|---|---|---|---|
| Component (A) | HPHPAH | | | 50 | - | - | - | - | - | - |
| | HX-220 | | | - | 50 | 50 | 50 | - | - | - |
| | HX-620 | | | - | - | - | - | 50 | 50 | 50 |
| | #195 | | | - | - | - | - | - | - | - |
| Component (B) | A-BPEF-2 | | | 25 | 25 | 25 | 25 | 25 | 25 | 25 |
| | BPE | | | 25 | 25 | 25 | 25 | 25 | 25 | 25 |
| Component (C) | Irgacure 819 | | | 0.5 | 0.2 | 0.5 | - | 0.2 | 0.5 | - |
| | OXE-02 | | | - | - | - | 1 | - | - | 1 |
| Component (D) | Tinuvin 460 | | | 2 | 2 | 2 | - | 2 | 2 | - |
| Antioxidant | IRGANOX 565 | | | 1 | - | - | - | - | - | - |
| Compatibility of materials | | | | Pass | Pass | Pass | Pass | Pass | Pass | Pass |
| Absorbance | | | | <0.1 | <0.1 | <0.1 | <0.1 | <0.1 | <0.1 | <0.1 |
| Suitability for spin coating process | | | | Excellent | Excellent | Excellent | Excellent | Excellent | Excellent | Excellent |
| Viscosity (mPa·s) | | | | 1300 | 1400 | 1400 | 1400 | 2500 | 2500 | 2500 |
| Cured sample preparation | | 365 nm | UV-LED | | | | ○ | | | ○ |
| | | 405 nm | UV-LED | ○ | ○ | ○ | | ○ | ○ | |
| Heat resistance 1 | | | | Excellent | Excellent | Excellent | Excellent | Excellent | Excellent | Excellent |
| Temperature at which mass of cured body is reduced by 2% by heating under nitrogen atmosphere (°C) | | | | 351 | 357 | 300 | 362 | 334 | 348 | 363 |
| Heat resistance 2 | | | | Good | Good | Good | Excellent | Excellent | Excellent | Excellent |
| Temperature at which mass of cured body is reduced by 2% by heating under reduced pressure (°C) | | | | 232 | 218 | 243 | 262 | 251 | 252 | 255 |
| Adhesiveness in high temperature condition (300°C, 1h, reduced pressure 20 Pa) | | | | Excellent | Excellent | Excellent | Excellent | Excellent | Excellent | Excellent |
| Width of color change in periphery (mm) | | | | 1 | 2 | 2 | 2 | 1 | 1 | 2 |
| Peeling due to heating | | | | None | None | None | None | None | None | None |
| UV Laser releasability | | | | Good | Excellent | Excellent | Pass | Good | Excellent | Pass |
| Minimum value of time required for achieving complete release (s) | | | | 28 | 9 | 7 | 49 | 28 | 12 | 49 |

| | | | | | | | | | | |
|---|---|---|---|---|---|---|---|---|---|---|
| * Values for component amounts indicate part by mass. | | | | | | | | | | |

**[Table 1b]**

| | | | Example 8 | Example 9 | Example 10 | Example 11 | Example 12 | Example 13 | Example 14 | Example 15 | Example 16 | Example 17 |
|---|---|---|---|---|---|---|---|---|---|---|---|---|
| Component (A) | HPHPAH | | 50 | 67 | 75 | - | - | - | - | - | - | - |
| | HX-220 | | - | - | - | 50 | 67 | 75 | - | - | - | - |
| | HX-620 | | - | - | - | - | - | - | 50 | 67 | 75 | - |
| | #195 | | - | - | - | - | - | - | - | - | - | 50 |
| Component (B) | A-BPEF-2 | | 50 | 33 | 25 | 50 | 33 | 25 | 50 | 33 | 25 | 50 |
| | BPE | | - | - | - | - | - | - | - | - | - | - |
| Component (C) | Irgacure 819 | | 0.2 | 0.2 | 0.2 | 0.2 | 0.2 | 0.2 | 0.2 | 0.2 | 0.2 | 0.5 |
| | OXE-02 | | - | - | - | - | - | - | - | - | - | - |
| Component (D) | Tinuvin 460 | | 2 | 2 | 2 | 2 | 2 | 2 | 2 | 2 | 2 | 2 |
| Antioxidant | IRGANOX 565 | | - | - | - | - | - | - | - | - | - | |
| Compatibility of materials | | | Pass | Pass | Pass | Pass | Pass | Pass | Pass | Pass | Pass | Pass |
| Absorbance | | | <0.1 | <0.1 | <0.1 | <0.1 | <0.1 | <0.1 | <0.1 | <0.1 | <0.1 | <0.1 |
| Suitability for spin coating process | | | Pass | Excellent | Pass | Pass | Excellent | Pass | Pass | Excellent | Excellent | Excellent |
| Viscosity (mPa-s) | | | 5700 | 1100 | 560 | 6400 | 1200 | 780 | 9200 | 2100 | 1200 | 3000 |
| Cured sample preparation | 365 nm | UV-LED | | | | | | | | | | |
| | 405 nm | UV-LED | ○ | ○ | ○ | ○ | ○ | ○ | ○ | ○ | ○ | ○ |
| Heat resistance 1 | | | Excellent | Excellent | Good | Excellent | Excellent | Good | Excellent | Excellent | Excellent | Good |
| Temperature at which mass of cured body is reduced by 2% by heating under nitrogen atmosphere (°C) | | | 320 | 312 | 298 | 332 | 321 | 297 | 352 | 351 | 350 | 270 |
| Heat resistance 2 | | | Good | Good | Good | Good | Good | Good | Good | Good | Good | Good |
| Temperature at which mass of cured body is reduced by 2% by heating under reduced pressure (°C) | | | 241 | 240 | 238 | 249 | 247 | 243 | 248 | 245 | 240 | 232 |
| Adhesiveness in high temperature condition (300°C, 1h, reduced pressure 20 Pa) | | | Good | Good | Pass | Good | Good | Pass | Good | Good | Pass | Pass |
| Width of color change in periphery (mm) | | | 5 | 5 | 8 | 5 | 5 | 8 | 5 | 5 | 7 | 10 |
| Peeling due to heating | | | None | None | None | None | None | None | None | None | None | None |
| UV Laser releasability | | | Good | Good | Pass | Excellent | Excellent | Good | Good | Good | Pass | Pass |
| Minimum value of time required for achieving complete release (s) | | | 28 | 28 | 49 | 9 | 12 | 18 | 28 | 28 | 49 | 49 |

| | | | | | | | | | | | | |
|---|---|---|---|---|---|---|---|---|---|---|---|---|
| * Values for component amounts indicate part by mass. | | | | | | | | | | | | |

**[Table 2]**

| | | | | Comparative Example 1 | Comparative Example 2 | Comparative Example 3 |
|---|---|---|---|---|---|---|
| Component (A) | HPHPAH | | | - | | |
| | HX-220 | | | 100 | | |
| | HX-620 | | | - | | |
| Component (B) | A-BPEF-2 | | | - | 100 | |
| | BPE | | | - | | 100 |
| Component (C) | Irgacure 819 | | | 0.2 | 0.5 | |
| | OXE-02 | | | - | | 1 |
| Component (D) | Tinuvin 460 | | | 2 | 2 | |
| Compatibility of materials | | | | Pass | Pass | Pass |
| Absorbance | | | | <0.1 | <0.1 | <0.1 |
| Suitability for spin coating process | | | | Failure | Failure | Failure |
| Viscosity (mPa.s) | | | | <100 | Solid | Solid |
| Cured sample preparation | | 365 nm | UV-LED | - | - | - |
| | | 405 nm | UV-LED | - | - | - |
| Heat resistance 1 | | | | - | - | - |
| Temperature at which mass of cured body is reduced by 2% by heating under nitrogen atmosphere (°C) | | | | | | |
| Heat resistance 2 | | | | - | - | - |
| Temperature at which mass of cured body is reduced by 2% by heating under reduced pressure (°C) | | | | | | |
| Adhesiveness in high temperature condition (300°C, 1h, reduced pressure 20 Pa) | | | | | | |
| Width of color change in periphery (mm) | | | | - | - | - |
| Peeling due to heating | | | | - | - | - |
| UV Laser releasability | | | | - | - | - |
| Minimum value of time required for achieving complete release (s) | | | | - | - | - |

| | | | | | | |
|---|---|---|---|---|---|---|
| * Values for component amounts indicate part by mass. | | | | | | |

**[Table 3]**

| UV Laser irradiation conditions | Apparatus: QLA-355 made by Quark Technology Co., Ltd. | | | | | | GAUSSIAN BEAM | | |
|---|---|---|---|---|---|---|---|---|---|
| Condition number | 1 | 2 | 3 | 4 | 5 | 6 | 7 | 8 | 9 |
| Work distance (mm) | 692 | 692 | 692 | 692 | 692 | 692 | 692 | 692 | 692 |
| Output (W) | 9.3 | 9.3 | 9.3 | 9.3 | 9.3 | 9.3 | 9.3 | 9.3 | 9.3 |
| Pulse energy (µJ) | 235 | 235 | 235 | 235 | 235 | 235 | 235 | 235 | 235 |
| Energy density (mJ/cm2) | 11968 | 11968 | 11968 | 11968 | 11968 | 11968 | 11968 | 11968 | 11968 |
| Spot diameter (µm) | 50 | 50 | 50 | 50 | 50 | 50 | 50 | 50 | 50 |
| Frequency (kHz) | 40 | 40 | 40 | 40 | 40 | 40 | 40 | 40 | 40 |
| Scan pitch (µm) | 100 | 150 | 200 | 250 | 300 | 350 | 400 | 450 | 500 |
| Scan speed (m/s) | 4 | 6 | 8 | 10 | 12 | 14 | 16 | 18 | 20 |
| 210 mm-square scanning time required (s) | 110.8 | 49.2 | 27.7 | 17.7 | 12.3 | 9.0 | 6.9 | 5.5 | 4.4 |
| Determination | Failure | Pass | Good | Good | Excellen t | Excellen t | Excellen t | Excellen t | Excellen t |

**[Table 4]**

| | | | | Example 3 | Example 4 | Example 6 |
|---|---|---|---|---|---|---|
| Component (A) | HX-220 | | | 50 | 50 | - |
| | HX-620 | | | - | - | 50 |
| Component (B) | A-BPEF-2 | | | 25 | 25 | 25 |
| | BPE | | | 25 | 25 | 25 |
| Component (C) | Irgacure 819 | | | 0.5 | - | 0.5 |
| | OXE-02 | | | - | 1 | - |
| Component (D) | Tinuvin 460 | | | 2 | - | 2 |
| Cured sample preparation | | 365 nm | UV-LED | | ○ | |
| | | 405 nm | UV-LED | ○ | | ○ |
| Outgas properties | | | | Excellent | Excellent | Excellent |
| "Pressure at the time of reaching 300°C" (Pa) | | | | 3.7*10⁻⁶ | 3.4*10⁻⁶ | 3.9*10⁻⁶ |

| | | | | | | |
|---|---|---|---|---|---|---|
| * Values for component amounts indicate part by mass. | | | | | | |

The results of Examples in Tables 1a, 1b and 4 and Comparative Examples in Table 2 show that the resin composition of the present invention has excellent compatibility, suitability for spin coating process and heat resistance.

In other words, when the component (B) was not used as in Comparative Example 1, the suitability for spin coating process cannot be obtained. When the component (A) was not used as in Comparative Examples 2 and 3, the compositions were solidified and unsuitable for spin coating process as expected.

The results in Table 4 show that the composition of the present invention has extremely excellent outgas properties.

The resin composition of the present invention ensures compatibility of materials and the lowest necessary viscosity for spin coating process, and thus has excellent adhesiveness, heat resistance and releasability at room temperature and high temperature.

The resin compositions according to Examples have suitability for UV laser release process and suitability for mechanical release process. The compositions enabled release, when a thin and sharp metal blade for making an opening was inserted into the end of the interface of the substrates of the laminate of a silicon wafer and a glass support prepared by the method described in the above Example and the laminate was horizontally fixed with the glass support facing upward, and after inserting the blade, upward stress was applied to the support on the upper side to extend the opening to release the wafer from the support.

Furthermore, as a method for evaluating the energy required for release, a method called Maszara test was used, in which a thin and sharp blade was inserted thereinto as described above only for a certain distance and how far the opening was extended at that stage was measured. The sample bonded by using the liquid resin having the composition of Example 1 exhibits a sufficiently low value even in that test.

The resin compositions according to Examples are suitable for UV laser release processes. The silicon wafer/glass support laminate prepared by the method described in the above Example was fixed on a fixer with the silicon wafer facing downward and the laminate was irradiated with UV laser QLA-355 manufactured by Quark Technology Co., Ltd. at an output of 9.3 W, a frequency of 40 kHz, and with a scan pitch of 200 µm and a beam diameter of 50 µm from the side of the glass support. Then, the release strength was measured in the same manner as in the above (3) Evaluation of suitability for mechanical release process, and as a result the release strength before UV irradiation of 3 N was reduced to 0 N.

### INDUSTRIAL APPLICABILITY

The composition provided by the present invention has excellent heat resistance, low outgas properties and releasability.

The composition of the present invention readily exhibits strong adhesiveness only by being irradiating with ultraviolet light or visible light in the manufacture of various electronic parts, optical parts and optical devices, and thus provides excellent operationability and productivity. Furthermore, the outgas from the cured body of the composition of the present invention is extremely small at a high temperature of 250°C. The composition of the present invention can be easily released after processing. Thus, various electronic parts, optical parts and optical devices obtained by bonding using the composition of the present invention can undergo a deposition process at a high temperature of more than 200°C or baking coating at high temperature.

Surface mount for circuit substrates has been applied even to optical parts such as image censors in addition to electronic parts such as ICs, resistors and inductors. In these cases the components are sent to soldering reflow at high temperature. Nowadays, in particular zinc-free soldering requires tough temperature conditions for soldering reflow. In such a manufacturing process the step at which the composition of the present invention is used is required to withstand heat treatment at high temperature sufficiently in order to improve quality of optical parts and optical devices or to increase productivity and production yield. Optical parts and optical devices manufactured by using the composition of the present invention can withstand the heat treatment at high temperature sufficiently, and thus are industrially highly useful.

## Claims

1. A composition for temporary bonding, comprising:
(A) a bifunctional (meth)acrylate not having a cyclic structure;
(B) a bifunctional (meth)acrylate having a cyclic structure; and
(C) a photo radical polymerization initiator.

2. The composition for temporary bonding according to claim 1, further comprising:
(D) an UV absorber.

3. The composition for temporary bonding according to claim 1 or 2, wherein the component (A) has a molecular weight of 250 or more.

4. The composition for temporary bonding according to any one of claims 1 to 3, wherein the component (A) is a bifunctional (meth)acrylate not having an alkyl ether structure.

5. The composition for temporary bonding according to any one of claims 1 to 4, wherein the component (A) is a bifunctional (meth)acrylate having an aliphatic hydrocarbon structure or an aliphatic hydrocarbon structure having a hydroxy group, and/or having an ester structure.

6. The composition for temporary bonding according to any one of claims 1 to 5, wherein the component (B) is liquid having a viscosity at 23°C of 500 mPa·s or more, or solid at 23°C.

7. The composition for temporary bonding according to any one of claims 1 to 6, wherein the component (B) has the cyclic structure including an aromatic ring.

8. The composition for temporary bonding according to claim 7, wherein the component (B) has a phenol ether structure.

9. The composition for temporary bonding according to claim 6 or 7, wherein the component (B) has a fluorene structure.

10. The composition for temporary bonding according to any one of claims 1 to 9, wherein the component (C) is a photo radical polymerization initiator that generates radical with light having a wavelength of 350 nm or more.

11. The composition for temporary bonding according to any one of claims 1 to 10, wherein the component (C) is one or more selected from the group consisting of bis(2,4,6-trimethylbenzoyl)phenylphosphine oxide, 2,4,6-trimethylbenzoyl diphenylphosphine oxide, bis(η⁵-2,4-cyclopentadien-1-yl)-bis(2,6-difluoro-3-(1H-pyrrol-1-yl)-phenyl)titanium, 2-benzyl-2-dimethylamino-1-(4-morpholinophenyl)-butan-1-on, 2-dimethylamino-2-(4-methylbenzyl)-1-(4-morpholin-4-ylphenyl)-butan-1-on, 1-[4-(phenylthio)phenyl]-1,2-octanedione 2-O-benzoyloxym, and 1-[9-ethyl-6-(2-methylbenzoyl)-9H-carbazol-3-yl]ethanone 1-(O-acetyloxime).

12. The composition for temporary bonding according to any one of claims 1 to 11, comprising 0.01 to 5 parts by mass of the component (C) based on 100 parts by mass of the total amount of the components (A) and (B).

13. The composition for temporary bonding according to any one of claims 1 to 12, wherein a mass ratio of the component (A) to the component (B) is 5 to 95:5 to 95 based on the total 100 parts by mass of the component (A) and the component (B).

14. The composition for temporary bonding according to any one of claims 1 to 13, further comprising:
(E) a monofunctional (meth)acrylate.

15. The composition for temporary bonding according to claim 14, comprising more than 0 parts by mass and 50 parts by mass or less of the component (E) based on the total 100 parts by mass of the components (A) and (B).

16. The composition for temporary bonding according to any one of claims 1 to 13, not comprising a (meth)acrylate other than the component (A) and the component (B).

17. The composition for temporary bonding according to any one of claims 1 to 16, further comprising:
(F) a polymer.

18. The composition for temporary bonding according to claim 17, comprising more than 0 parts by mass and 50 parts by mass or less of the component (F) based on the total 100 parts by mass of the components (A) and (B).

19. The composition for temporary bonding according to any one of claims 1 to 18, wherein a viscosity at 23°C is 100 to 10,000 mPa·s.

20. An adhesive for temporary bonding, comprising the composition for temporary bonding according to any one of claims 1 to 19.

21. A bonded body obtained by adhering a substrate using the adhesive for temporary bonding according to claim 20.

22. A cured body obtained by curing the composition for temporary bonding according to any one of claims 1 to 19.

23. The cured body according to claim 22, being a single layer cured body.

24. The cured body according to claim 22 or 23, wherein a mass reduction reaches 2% at a temperature of 250°C or more under nitrogen atmosphere.

25. The cured body according to any one of claims 22 to 24, wherein a mass reduction reaches 2% at a temperature of 250°C or more under reduced pressure environment of 30 to 100 Pa.

26. A bonded body obtained by adhering a substrate using an adhesive for temporary bonding, the adhesive comprising:
(A) a bifunctional (meth)acrylate not having a cyclic structure;
(B) a bifunctional (meth)acrylate having a cyclic structure; and
(C) a photo radical polymerization initiator,
wherein the adhesive for temporary bonding is cured with light having a wavelength of 350 nm or more, and the substrate is released by laser light having a wavelength of less than 385 nm.

27. A method for producing a semiconductor wafer, the method comprising the steps of:
applying an adhesive for temporary bonding according to claim 20 to a semiconductor wafer substrate and/or a support member to bond the semiconductor wafer substrate and the support member;
curing the adhesive for temporary bonding by irradiating light having a wavelength of 350 nm to 700 nm to obtain a bonded body; and
irradiating the bonded body with laser light having a wavelength of less than 385 nm to release the semiconductor wafer substrate.

28. The production method according to claim 27, wherein the cured adhesive for temporary bonding constitutes a single layer in the bonded body.

29. The adhesive for temporary bonding according to claim 20 whose application is UV laser release.

30. A cured body, comprising:
a first cured layer comprising the composition for temporary bonding containing component (A), component (B) and component (C) and not having component (D); and
a second cured layer comprising the composition according to claim 2, wherein a component concentration distribution varies in the thickness direction.

31. A cured body, comprising:
a first cured layer obtained by curing the composition according to claim 1 comprising component (A), component (B) and component (C); and
a second cured layer obtained by applying an UV absorber on the first cured layer,
wherein a component concentration distribution varies in the thickness direction.

32. A cured body, comprising:
a first cured layer obtained by curing the composition according to claim 1 comprising component (A), component (B) and component (C); and
a light heat converting (LTHC) cured layer.

33. The cured body according to any one of claims 30 to 32 satisfying all the following conditions:
· in a light transmittance of the cured body having a thickness of 50 µm, a light transmittance in a wavelength region of 395 nm or more among the wavelengths of a light source used for curing is 70% or more;
· in a light transmittance of the cured body having a thickness of 50 µm, a light transmittance in a wavelength region of 350 nm or more and less than 395 nm among the wavelengths of a light source used for curing is 20% or more; and
· in a light transmittance of the cured body having a thickness of 50 µm, a light transmittance at a wavelength (355 nm) of UV laser used for UV laser release is 1% or less.

34. A structure, comprising:
the cured body according to any one of claims 30 to 33; and
an adherend.

35. A method for producing a structure, the method comprising the steps of:
applying, on a wafer, a composition for temporary bonding comprising component (A), component (B) and component (C), and not having component (D) to cure partially;
applying the composition according to claim 2 on the partially cured composition; and
further putting a transparent substrate on the applied composition for temporary bonding to photo-cure.

36. A method for producing a structure, the method comprising the steps of:
applying, on a wafer, a composition for temporary bonding comprising component (A), component (B) and component (C), and not having component (D) to cure partially as needed;
applying the composition according to claim 2 on a transparent substrate to cure partially as needed; and
a step for firmly attaching faces of the wafer and the transparent substrate on which the composition for temporary bonding has been applied and then bonding by photo-curing.

37. A method for producing a structure, the method comprising the steps of:
applying, on a wafer, the composition according to claim 1 comprising component (A), component (B) and component (C), and not having a component (D) to cure partially as needed;
applying a light heat converting (LTHC) layer on a transparent substrate and drying to cure; and
firmly attaching the face of the wafer on which the composition for temporary bonding has been applied and the face of the transparent substrate on which the LTHC layer has been applied and then bonding by photo-curing.
